Europäisches Patentamt

European Patent Office

Office européen des brevets

(11) Veröffentlichungsnummer: **0 177 100**
**B1**

(12) **EUROPÄISCHE PATENTSCHRIFT**

(45) Veröffentlichungstag der Patentschrift: **08.08.90**

(21) Anmeldenummer: **85201562.7**

(22) Anmeldetag: **27.09.85**

(51) Int. Cl.⁵: **H 03 L 7/06,** H 03 D 13/00,
H 04 N 5/12

(54) **Phasenvergleichsschaltung.**

(30) Priorität: **03.10.84 DE 3436192**

(43) Veröffentlichungstag der Anmeldung:
**09.04.86 Patentblatt 86/15**

(45) Bekanntmachung des Hinweises auf die
Patenterteilung:
**08.08.90 Patentblatt 90/32**

(84) Benannte Vertragsstaaten:
**BE DE FR GB IT**

(56) Entgegenhaltungen:
EP-A-0 024 878
DE-A-3 310 581
DE-B-2 324 853
US-A-3 821 470

FUNKSCHAU, 48. Jahrgang, Heft 7, März 1976,
München, DE, M. KASZTANTOWICZ "Phase-
Locked-Loop-Systeme in der Praxis" Seiten
257-259

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips'
Gloeilampenfabrieken
Groenewoudseweg 1
NL-5621 BA Eindhoven (NL)**
(84) **BE FR GB IT**

(72) Erfinder: **Oldach, Detlef
Dahlgrünring 6
D-2102 Hamburg 93 (DE)**

(74) Vertreter: **Hartmann, Heinrich, Dipl.-Ing. et al
Philips Patentverwaltung GmbH Wendenstrasse
35 Postfach 10 51 49
D-2000 Hamburg 1 (DE)**

**Beschreibung**

Die Erfindung betrifft eine Schaltungsanordnung zur Detektion der Phasenverschiebung zwischen einem Eingangssignal und einem Referenzsignal, die ein vom Phastenunterschied abhängiges Ausgangssignal durch Integration des Eingangssignals während eines zum Referenzsignal synchronen Integrationsintervalls erzeugt.

Eine solche Schaltungsanordnung ist aus der Zeitschrift "Funkschau", 1976, Heft 7, Seite 258, bekannt. Derartige Schaltungsanordnungen können in Phasenregelkreisen eingesetzt werden, die die Phase und Frequenz eines Oszillators so regeln, daß dessen Phase mit der Phase eines Referenzsignals übereinstimmt. Diese bekannte Schaltungsanordnung vergleicht die Phase eines sinusförmige Eingangssignals, d.h. eines zur Nullinie symmetrischen Signals, und die Phase eines impulsförmiges Referenzsignals. Während eines zum impulsförmigen Referenzsignal synchronen Zeitintervalls gibt die Phasenvergleichsschaltung ein zum symmetrischen Eingangssignal proportionales Ausgangssignal ab, das ein nachgeschalteter Tiefpaß integriert. In der Sollphasenlage, d.h. wenn keine Phasenverschiebung vorhanden ist, ist das Ausgangssignal des Tiefpasses Null, weil das Integrationsintervall dann so liegt, daß ein Teil des symmetrischen eingangssignals vor dem Nulldurchgang und ein darauffolgender gleich langer Teil nach dem Nulldurchgang integriert wird. Diese Phasenvergleichsschaltung kann also keine zur Nullinie unsymmetrischen Eingangssignale verarbeiten.

Es wird auch auf die Dokumente DE—A—3 310 581 und DE—B—2 324 853 verweisen, die ebenfalls Phasenvergleichsschaltungen mit einem Integrator beschreiben.

Der Erfindung liegt die Aufgabe zugrunde, eine Phasenvergleichsschaltung der eingangs genannten Art so auszubilden, daß sie zur Nullinie unsymmetrische, insbesondere inpulsförmige Eingangssignale verarbeiten kann.

Dazu weist die erfindungsgemäße Schaltungsanordnung das Kennzeichen auf, daß sie einer Integratoranordnung zum Integrieren des Eingangssignals während zweier aufeinanderfolgender definierter Integrationsintervalle und eine Überlagerungsschaltung zur Bildung eines der Differenz der an der Integratoranordnung erzeugten gewichteten Integralwerte entsprechenden Signals enthält und daß die Gewichtungsfaktoren und/oder die Dauer der Integrationsintervalle voneinander abweichen, wobei dieses Signal den Ausgangssignal der Schaltungsanordnung bildet.

Bei der erfindungsgemäßen Schaltungsanordnung müssen die Integrationsintervalle nicht, wie bei der bekannten Schaltungsanordnung, symmetrisch zur Nullinie des Eingangssignals liegen. Die beiden Integrationsintervalle können unterschiedlich lang sein und sie können direkt hintereinander oder in einem geweissen zeitlichen Abstand aufeinanderfolgen. Die Integrationsergebnisse werden so gewichtet, daß bei einem definierten Phasenunterschied das Ausgangssignal der Phasenvergleichsschaltung Null ist. Die Wichtung und Überlagerung entspricht also einer Differenzbildung der beiden Integrationsergebnisse. Bei einem impulsförmigen Eingangssignal wird vorteilhafterweise das erste Integrationsintervall innerhalb der Anstiegszeit und das zweite Integrationsintervall innerhalb des Impulsdaches des inpulsförmigen Eingangssignals liegen. Von Vorteil ist es, wenn lange Integrationsintervalle gewählt werden, denn dann werden Störungen, die auftreten können, schwächer bewertet. Allerdings dürfen diese Integrationsintervalle nicht zu lang gewählt werden, da dann die Linearität der Phasenvergleichschaltung vermindert wird.

In einer ersten Weiterbildung der Erfindung ist vorgesehen, daß das Eingangssignal einem Eingang eines Multiplexers invertiert und einem anderen Eingang nicht invertiert zugeführt wird, daß die Integratoranordnung einen Integrator enthält, dessen Eingang mit dem Ausgangs des Multiplexers verbunden ist, daß eine vom Referenzsignal gesteuerte Zeitgeberanordnung zum Aktivieren des Integrators während der Integrationsintervalle und zum Umschalten des Multiplexers zwischen den Zeitintervallen vorgesehen ist und daß der Ausgang des Integrators den Ausgangs der Schaltungsanordnung bildet.

Besonders günstig ist bei dieser Schaltungsanordnung, daß die beiden Integrationen in einem Integrator vorgenommen werden und die Überlagerung gleichzeitig in diesem Intergrator stattfindet. Die Gewichtung des Eingangssignals wird vor dem Integrator vorgenommen und die Überlagerung wird durch einen Addierer realisiert, da während eines Integrationsintervalls das Eingangssignal invertiert zugeführt wird.

In einer zweiten Weiterbildung der Erfindung ist vorgesehen, daß die Integrationsanordnung zwei Integratoren umfaßt, an deren Eingängen das Eingangssignal anliegt, daß eine vom Referenzsignal gesteuerte Zeitgeberanordnung zum Aktivieren ds einen Integrators während des ersten Zeitintervalles und des zweiten Integrators während des zweiten Zeitintervalls vorgesehen ist, daß die gewichteten Ausgangssignale der beiden Integratoren den Eingängen der Überlagerungsschaltung zugeführt werden und daß der Ausgangs der Schaltungsanordnung mit dem Ausgang der Überlagerungsschaltung gekoppelt ist.

Bei dieser Schaltungsanordnung läßt sich die Abhängigkeit des Ausgangssignals von der Amplitude des Eingangssignals für den Fall, daß das zweite Integrationsintervall jeweils mit den Impulsdächern des Eingangssignals zusammenfällt, dadurch beseitigen, daß eine Divisionsschaltung das Ausgangssignal der Überlagerungsschaltung durch das Ausgangssignal des Integrators, der während des zweiten Integrationsintervalls aktiviert ist, dividiert.

Für die genannten Ausführungsformen der Erfinding ist eine analoge Signalverarbeitung möglich. Vorteilhaft ist aber eine digitale Signalverarbeitung, bei der das Eingangssignal als Folge digitalisierter Abtastwerte in Dualdarstellung vorliegt und die dadurch gekennzeichnet ist, daß das eingangssignal über einen Analog/Digital-Wandler zugeführt wird, dessen Abtastfrequenz ein ganzzahliges Vielfaches der Frequenz des Referenzimpulses ist, und daß der Integrator bzw. die Integratoren von der Zeitgeberanordnung so gesteuert werden, daß jeweils eine feste Zahl von Abtastwerten des eingangssignals integriert wird. In diesem Fall läßt sich eine digitale Schaltungsanordnung auch mit weniger Aufwand als eine analoge aufbauen und kann außerdem mit einer integrierten Schaltung einfach realisiert werden, die es ermöglicht, daß Phasenabweichungen erkannt werden, die wesentlich geringer als ein Abtastwert sind.

Anhand der Zeichnungen werden im folgenden die Erfindung sowie weitere Vorteile und Ergänzungen näher beschrieben und erläutert. Es zeigt:

Fig. 1 eine schematische Schaltung eines Phasenregelkreises mit einer Phasenvergleichsschaltung für eine digitale Signalverarbeitung,

Fig. 2 einen Teil von Fig. 1 mit einer ersten Ausführungsform der Phasenvergleichsschaltung,

Fig. 3 die Zeitdiagramme der in Fig. 2 auftretenden Signale,

Fig. 4 einen Teil von Fig. 1 mit einer zweiten Ausführungsform der Phasenvergleichsschaltung und

Fig. 5 die Zeitdiagramme der in Fig. 4 auftretenden Signale.

Ein positives analoges impulsförmige Eingangssignal, z.B. Zeilensynchronimpulse eines Fernsehsignals, wird durch einen Analog/Digital-Wandler 1 digitalisiert und in einem digitalen Teifpaß 2 weiter verarbeitet. Der Tiefpaß mit einer Grenzfrequenz von 1 MHz verbessert das Signal/Rausch-Verhältnis und bewirkt, daß das Ausgangssignal des Tiefpasses eine definierte Anstiegsflanke erhält. Das Ausgangssignal des digitalen Teifpasses 2 ist ein Eingangssignal Ue einer Phasenvergleichsschaltung 3. Ein Oszillator 4 erzeugt ein Taktsignal mit einer Frequenz von 13,5 MHz. Das Taktsignal wird auf den Analog/Digital-Wandler 1, auf den Tiefpaß 2 und auf einen Frequenzteiler 5 gegeben. Das Ausgangssignal des Frequenzteilers 5 ist eine analoges impulsförmiges Referenzsignal mit einer Frequenz von 15,625 kHz (das ist der 864. Teil der Abtastfrequenz). Das Referenzsignal Ur wird einem Eingang und das Taktsignal dem anderen Eingang einer Zeitgeberanordnung 6 zugeführt. Die Zeitgeberanordnung 6 gibt an die Phasenvergleichsschaltung 3 Steuersignal ab, deren zeitliche Lage vom Nulldurchgang des impulsförmigen Referenzsignals Ur abhängig ist. Das digitale Ausgangssignal Up der Phasenvergleichsschaltung wird auf den Oszillator 4 rückgekoppelt. Das digitale Ausgangssignal Up kann dem Oazillator 4 z.B. über einen nicht näher dargestellten Digital/Analog-Wandler zugeführt werden. Mit dem analogen Ausgangssignal des Digital/Analog-Wandlers wird die Frequenz des Oszillators 4 so geändert, daß des Referenzsignal Up also in Frequenz und Phase dem Eingangssignal angeglichen wird.

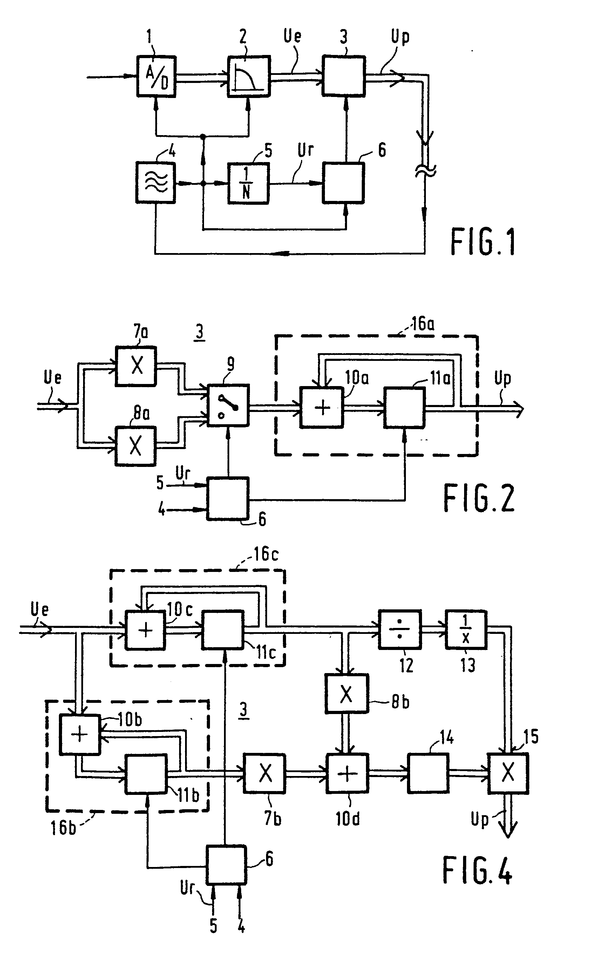

In Fig. 2 ist eine erste Ausführungsform der Phasenvergleichsschaltung dargestellt. Das digitale impulsförmige Eingangssignal Ue wird über zwei Multiplizierer 7a und 8a den beiden Eingängen eines Multiplexers 9 zugeführt. Der Multiplizierer 7a multipliziert das Eingangssignal mit dem Faktor 4 und der Multiplizierer 8a mit dem Faktor −1. Der Multiplizierer 7a läßt sich z.B. durch eine Shift-Stufe und der Multiplizierer 8a durch NAND-Gatter realisieren. Dem Multiplexer 9 is ein Integrator (16a) nachgeschaltet.

Dieser enthält einen Addierer 10a und ein Register 11a. Das eingangssignal des Integrators 16a wird dem Addierer 10a und das Ausgangssignal des Addierers 10a dem Register 11a zugeführt. Das Ausgangssignal des Registers 11a, das auch das Ausgangssignal des Integrators 16a und der Phasenvergleichsschaltung ist, wird auf den Addierer 10a rückgekoppelt. Die Zeitgeberanordnung 6, die z.B. mit Zählern realiseirt wird, ist mit dem Multiplexer 9 und dem Register 11a verbunden. Durch die Vorderflanke des impulsförmigen Referenzsignals Ur werden die Zähler gestartet. Die Zähler bestimmen die Anzahl der Takte, die dem Register 11a zugeführt werden und die Anzahl der Takte, nach denen der Multiplexer 9 durch ein Signal der Zeitegeberanordnung 6 umgeschaltet wird.

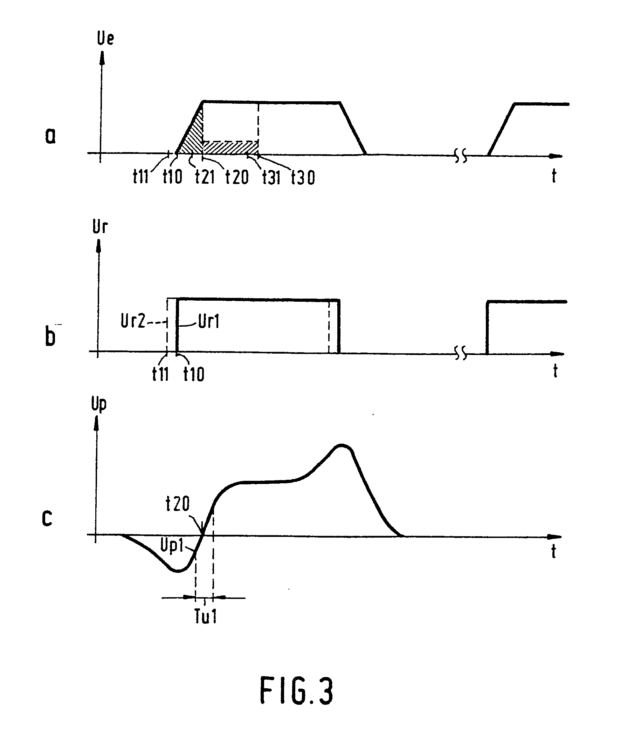

Fig. 3 verdeutlicht die Wirkungsweise der Schaltungsanordnung nach Fig. 2. Das Diagramm a zeigt das Eingangssignal Ue der Phasenvergleichsschaltung. Zur Veranschaulichung ist das Signal mit einem kontinuierlichen Kurvenverlauf dargestellt. Das Daigramm b zeigt zwei impulsförmige Referenzsignale, wobei das Referenzsignal Ur1 die Sollphasenlage und das Referenzsignal Ur2 eine davon abweichende Phasenlage hat. Zuerst wird die Funktionsweise der Schaltung bei Sollphasenlage betrachtet. Zum Zeitpunkt t10 wird durch die Vorderflanke des Referenzsignals Ur1 die Zeitgeberanordnung 6 so gesteuert, daß das Register 11a auf Null gesetzt und freigegeben wird und der Multiplexer 9 so geschaltet wird, daß das durch den Multiplizierer 7a mit dem Faktor 4 multiplizierte Eingangssignal am Addierer 10a anliegt. Der Abtastwert des mit dem Faktor 4 multiplizierten Eingangssignals wird im Register 11a gespeichert und beim zweiten Takt zum zweiten Abtastwert addiert. Das Additionsergebnis wird wieder im Register 11a gespeichert. Die einzelnen Abtastwerte werden weiter bei jedem Takt addiert.

Das erste Integrationsintervall ist zum Zeitpunkt t20 beendet und die Zeitgeberanordnung 6 schaltet den Multiplexer 9 um, so daß das durch den Multiplizierer 8a mit dem Faktor −1 multiplizierte Eingangssignal dem Addierer 10a zugeführt wird. Die negativen Abtastwerte werden zum Additionsergebnis des ersten Integrationsintervalls addiert. Zum Zeitpunkt t30, am Ende des zweiten Integrationsintervalls, das doppelt so lang ist wie das erste, sperrt die Zeitgeberanordnung 6 das Register 11a, und das Ausgangssignal Up hat bei Sollphasenlage den Wert Null. Dieses Ergebnis wird noch einmal durch den Vergleich der beiden unterschiedlich gekennzeichneten Flächen im Diagramm a der Fig. 3 verdeutlicht. Sie haben bei Sollphasenlage den gleichen Betrag. Die Fläche im zweiten Integrationsintervall ist zur Veranschaulichung um den Faktor 4 vermindert, da während des ersten Integrationsinvertalls eine Multiplikation mit diesem Faktor erfolgte.

Wie man auch sieht, fällt bei Sollphasenlage das erste Integrationsintervall mit der Anstiegsflanke des impulsförmigen Eingangssignals und das zweite Integrationsintervalle mit dem Inpulsdach des impulsförmigen Eingangssignals zeitlich zusammen. Es ist auch möglich, das erste Integrationsintervall kürzer zu wählen und später beginnen zu lassen und das zweite Integrationsintervall kürzer oder länger zu wählen und später beginnen zu lassen. Soll dieselbe Sollphasenlage wie oben bei den beiden Signalen vorliegen, so müssen bei Veränderung der Integrationsintervalle evtl. die Faktoren der Multplizierer 7a und 8a verändert werden. Werden die beiden Integrationsintervalle gleich land gewählt, dann müssen die Gewichtungsfaktoren unterschiedlich groß sein, oder werden die Gewichtungsfaktoren dem Betrage nach gleich gewählt, dann müssen die Integrationsintervalle unterschiedlich lang sein.

Wie Diagramm b zeigt, weicht das Referenzsignal Ur2 von der Sollphasenlage ab. Das erste Integrationsintervall beginnt zum Zeitpunkt t11 und endet zum Zeitpunkt t21 (Fig. 3). Das zweite Integrationsintervall beginnt zum Zeitpunkt t21 und endet zum Zeitpunkt t31. Anch Abschluß der Integration erhält man am Ausgang der Phasenvergleichsschaltung ein negatives Ausgangssignal. Die im Diagramm c dargestellte Kennlinie der Phasenvergleichsschaltung zeigt das Ausgangssignal Up in Abhängigkeit vom Umschaltzeitpunkt. Der Umschaltzeitpunkt ist das jeweilige Ende des ersten Integrationsintervalls. Das vom Referenzsignal Ur2 abhängige negative Ausgangssignal ist in der Kennlinie mit Up1 bezeichnet. In dem auf der Abszisse der Kennlinie mit Tu1 gekennzeichneten Bereich ist das Ausgangssignal annähernd proportional der Phasenabweichung zwischen dem impulsförmigen Eingangssignal und dem Referenzsignal.

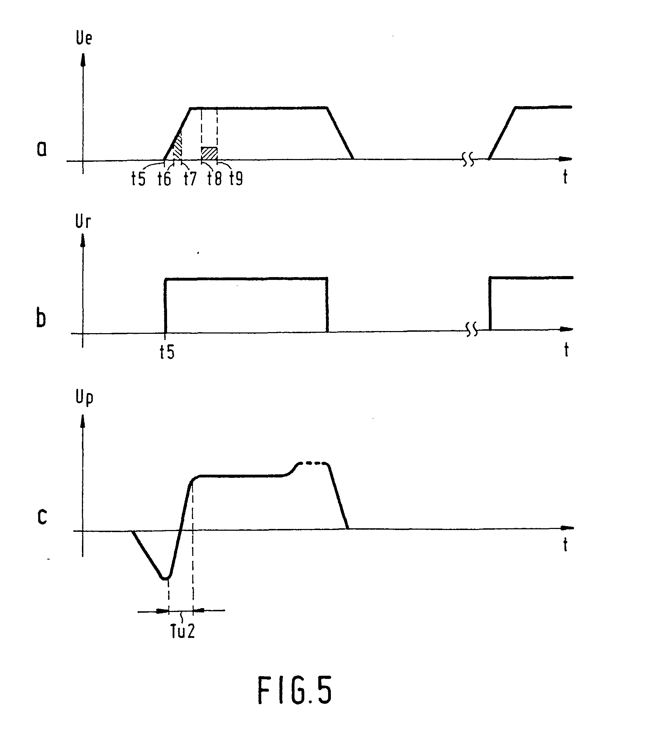

In Fig. 4 ist ein zweites Ausführungsbeispiel dargestellt. Das digitale impulsförmige Eingangssignal Ue wird zwei Integratoren 16b und 16c, die wei der Integrator 16a aufgebaut sind, zugeführt. Die Register 11b und 11c der beiden Integratoren sind mit der Zeitgeberanordnung 6 verbunden. Das Ausgangssignal des ersten Integrators 16b wird durch einen Multiplizierer 7b mit einem Faktor 4 multipliziert und das Ausgangssignal des zweiten Integrators 16c wird durch einen Multiplizierer 8b mit einem Faktor −1 multipliziert. Anschließend werden die beiden Ausgangssignale der Multiplizierer 7b und 8b in einem Addierer 10d überlagert. Das Ausgangssignal des zweiten Integrators 16c wird auf ein Divisionsschaltung 12 und eine Schaltung 13 zur Kehrwertbildung gegeben. Das Ausgangssignal des Addierers 10d wird einem Überlaufbegrenzer 14 zugeführt. In einem Multiplizierer 15 werden das Ausgangssignal des Überlaufbegrenzers 14 und das Ausgangssignal der Schaltung 13 zur Kehrwertbildung multipliziert. Der Überlaufbegrenzer 14 hat die Funktion, das Ausgangssignal des Addierers 10d von einem bestimmten Wert an zu begrenzen. Dadurch wird der Aufwand für den Multiplizierer 15 vermindert, da dieser dann nur für den maximalen Wert des Ausgangssignals des Überlaufbegrenzers 14 ausgelegt werden muß.

Fig. 5 veranschaulicht die Wirkungsweise der Schaltungsanordnung nach Fig. 4. Das Diagramm a zeigt wieder das Eingangssignal Ue, das Diagramm b das Referenzsignal Ur und das Diagramm c die Kennlinie der Phasenvergleichsschaltung. Die Wirkungsweise der Schaltung sei bei Sollphasenlage betrachtet. Zum Zeitpunkt t5 wird durch die Vorderflanke des impulsförmigen Referenzsignals Ur die Zeitgeberanordnung 6 so gesteuert, daß zum Zeitpunkt t6 zu Beginn des ersten Integrationsintervalls das Register 11b freigegeben wird und der erste Integrator 16b damit aktiviert ist. Der Integrator 16b addiert die Abtastwerte des impulsförmigen Eingangssignals des ersten Integrationsintervalls. Zum Zeitpunkt t7 ist das erste Integrationsintervall beendet, und das Register 11b wird gesperrt. Das zweite Integrationsintervall beginnt zum Zeitpunkt t8. Das Register 11c wird von der Zeitgeberanordnung 6 freigegeben und der zweite Integrator 16c aktiviert, der die Abtastwerte des zweiten Integrationsintervalls addiert. Das zweite Integrationsintervall ist zum Zeitpunkt t9 beendet, und das Register 11c wird gesperrt. Das Integrationsergebnis des zweiten Integrators 16c wird über den Multiplizierer 8b und das im Register 11b gespeicherte Integrationsergebnis des ersten Integrationsintervalls wird über den Multiplizierer 7b auf den Addierer 10d gegeben. Bei Sollphasenlage ist das Ausgangssignal des Addierers 10d Null. Dieses Ergebnis wird wie im Diagramm a der Fig. 3 auch im Diagramm a der Fig. 4 durch den Vergleich der unterschiedlich gekennzeichnet Flächen verdeutlicht.

Wie aus Diagram c der Fig. 3 zu erkennen ist, ist das Ausgangssignal Up in dem auf der Abszisse der Kennlinie der Phasenvergleichsschaltung mit Tu1 gekennzeichneten Bereich annähernd proportional der Phasenabweichung zwischen Referenzsignal und dem inpulsförmigen Eingangssignal. Da aber das Ausgangssignal Up noch von der Höhe der Amplitude des Eingangssignals abhängig ist, ist eine Normierungsschaltung vorgesehen. Diese besteht aus der Divisionsschaltung 12, aus der Schaltung 13 zur Kehrwertbildung und dem Multiplexer 15. Das im Register 11c des Integrators 16c gespeicherte Integrationsergebnis wird in der Divisionsschaltung 12 durch die Anzahl der Abtastwerte des zweiten Integrationsintervalles dividiert. Das Ausgangssignal des Überlaufbegrenzers 14 wird mit dem Kehrwert des Ausgangssignales der Divisionsschaltung 12 multipliziert, und am Ausgang des Multiplizierers 15 erhält man das normierte Ausgangssignal der Phasenvergleichsschaltung.

Die Kennlinie dieser Phasenvergleichsschaltung von Fig. 4 ist im Diagramm c der Fig. 5 dargestellt. Der Umschaltzeitpunkt ist das jeweilige Ende des ersten Integrationsintervalls. Der Bereich der Kennlinie, in dem der Überlaufbegrenzer aktiv ist, ist durch eine unterbrochene Kurve dargestellt. Der lineare Bereich dieser Kennlinie, auf der Abszisse durch Tu2 gekennzeichnet, ist durch die Wahl kürzerer Integrationsintervalle vergrößert werden. Die Länge der Integrationsintervalle beeinflußt also die Linearität der Kennlinie der Phasenvergleichsschaltung. Werden die Integrationsintervalle verkürzt, so verändert sich aber auch die Rauschanfälligkeit der Phasenvergleichsschaltung, da einzelne Rauschanteile stärker bewertet werden.

Die Empfindlichkeit der Phasenvergleichsschaltung hängt nicht nur von der Länge der Integrationsintervalle, sondern auch von der Anzahl der Quantisierungsstufen der Zeilensynchronimpulse ab. Die Schaltung kann Phasenabweichungen zwischen dem Referenzsignal un den Zeilensynchronimpulsen mit einer Empfindlichkeit von weniger als einem Takt — theoretisch bis zu 1/M-Takten — detektieren, wobei M die Anzahl der Quantisierungsstufen ist. Das gilt allerdings nur, wenn die Zeilensynchronimpulse Anstiegsflanken haben, da die zeitliche Dauer des ersten Integrationsintervalls kleiner oder gleich der Anstiegszeit der Zeilensynchronimpulse ist. Dies wird durch den digitalen Tiefpaß 2 sichergestellt. Entfallen auf die Zeilensynchronimpulse bie 7 bit Auflösung des FBAS-Signals 40 Quantisierungsstufen, so können Phasenabweichnungen von maximal 0,025 Takten noch detektiert werden.

Die erfindungsgemäße Schaltungsanordnung eignet sich besonders für die sehr genaue Detektierung von Phasenabweichungen, sie hat aber nur einen schmalen linearen Kennlinienbereich (Arbeitsbereich). Durch Kombination der Schaltungsanordnung mit einer Phasenvergleichsschaltung, die einen größeren linearen Kennlinienbereich aufweist, aber eine geringere Empfindlichkeit besitzt, kann die Erfindung vorteilhaft genutzt werden. Zuerst regelt die Phasenvergleichsschaltung geringerer Empfindlichkeit die Phasenlage zwischen Eingangs- und Referenzsignal (Grobregelung). Liegt die Phasenabweichung im Arbeitsbereich der erfindungsgemäßen Schaltungsanordnung, übernimmt diese die weitere Regelung (Feinregelung).

**Patentansprüche**

1. Schaltungsanordnung zur Detektion der Phasenverschiebung zwischen einem Eingangssignal (Ue) und einem Referenzsignal (Ur), die ein vom Phasenunterschied abhängiges Ausgangssignal durch Integration des Eingangssignals während eines zum Referenzsignal synchronen Integrationsintervalls erzeugt, dadurch gekennzeichnet, daß die Schaltungsanordnung eine Integrationsanordnung (16a, b, c) zum Integrieren des Eingangsssignals während zweier aufeinanderfolgender definierter Integrationsintervalle und eine Überlagerungsschaltung (10a, d) zur Bildung eines der Differenz der an der Integratoranordnung erzeugten gewichteten Integralwerte entsprechenden Signals enthält und daß die Gewichtungsfaktoren und/oder die Dauer der Integrationsintervalle voneinander abweichen, wobei dieses Signal das Ausgangssignal der Schaltungsanordnung bildet.

2. Schaltungsanordnung nach Anspruch 1, dadurch gekennzeichnet, daß das Eingangssignal einem Eingang eines Multiplexers (9) invertiert und einem anderen Eingang nicht invertiert zugeführt wird, daß die Integratoranordnung einen Integrator (16a) enthält, dessen Eingang mit dem Ausgang des Multiplexers verbunden ist, daß eine vom Referenzsignal gesteuerte Zeitgeberanordnung (6) zum Aktivieren des Integrators während der Integrationsintervalle und zum Umschalten des Multiplexers zwischen de Zeitintervallen vorgesehen ist und daß der Ausgang des Integrators den Ausgang der Schaltungsanordnung bildet.

3. Schaltungsanordnung nach Anspruch 1, dadurch gekennzeichnet, daß die Integrationsanordnung zwei Integratoren (16a, b, c) umfaßt, an deren Eingängen das Eingangssignal anliegt, daß eine vom Referenzsignal gesteuerte Zeitgeberanordnung (6), zum Aktivieren des einen Integrators während des ersten Zeitintervalls und des zweiten Integrators während des zweiten Zeitintervalls vorgesehen ist, daß die gewichteten Ausgangssignale der beiden Integratoren den Eingängen der Überlagerungsschaltung (10d) zugeführt werden und daß der Ausgang der Schaltungsanordnung mit dem Ausgang der Überlagerungsschaltung gekoppelt ist.

4. Schaltungsanordnung nach einem der vorhergehenden Ansprüche, dadurch gekennzeichnet, daß das erste Integrationsintervall kürzer oder gleich der Anstiegszeit eines impulsförmigen Eingangssignals ist und daß die beiden Integrationsintervalle in einem solchen zeitlichen Abstand aufeinanderfolgen, daß bei einem definierten Phasenunterschied das erste Integrationsintervall mit der Anstiegsflanke des Eingangssignals und das zweite Integrationsintervall mit dem Impulsdach des Eingangsignals zeitlich zusammenfällt und daß die Längen der beiden Integrationsintervalle und die Gewichtungsfaktoren so gewählt sind, daß das Ausgangssignal einen definierten Wert hat.

5. Schaltungsanordnung nach Anspruch 3, dadurch gekennzeichnet, daß eine Divisionsschaltung (12), das Ausgangssignal der Überlagerungsschaltung durch das Ausgangssignal der Integrators, der während des zweiten Integrationsintervalls aktiviert ist, dividiert.

6. Schaltungsanordnung nach Anspruch 5, dadurch gekennzeichnet, daß der Überlagerungsschaltung eine Begrenzerschaltung (14) nachgeschaltet ist.

7. Schaltungsanordnung nach Anspruch 2, dadurch gekennzeichnet, daß die zeitliche Lage der von der Zeitgeberanordnung an den Multiplexer abgegebenen Steuersignale vom Nulldurchgang des impulsförmigen Referenzsignals abhängig ist.

8. Schaltungsanordnung nach einem der vorhergehenden Ansprüche, dadurch gekennzeichnet, daß das Eingangssignal über einen Analog-Digital-Wandler (1) zugeführt wird, dessen Abtastfrequenz ein ganzzahliges Vielfaches der Frequenz des Referenzimpulses ist und daß der Integrator bzw. die Integratoren von der Zeitgeberanordnung so gesteuert werden, daß jeweils eine feste Zahl von Abtastwerten des Eingangssignals integriert wird.

9. Schaltungsanordnung nach Anspruch 8, dadurch gekennzeichnet, daß das Eingangssignal über einen Tiefpaß (2) zugeführt wird.

**Revendications**

1. Montage de circuit pour la détection du déphasage entre un signal d'entrée (Ue) et un signal de référence (Ur), qui produit un signal de sortie dépendant de la difference de phase par intégration du signal d'entrée pendant un intervalle d'intégration synchrone par rapport au signal de référence, caractérisé en ce qu'il contient un dispositif intégrateur (16a, b, c) pour l'intégration du signal d'entrée pendant deux intervalles d'intégration définis successifs et un circuit de superposition (10a, d) pour la formation d'un signal correspondant à la différence des valeurs d'intégrales pondérées produits dans le dispositif intégrateur et que les facteurs de pondération et/ou la durée des intervalles d'intégration différent l'un de l'autre, ce signal formant le signal de sortie du montage de circuit.

2. Montage de circuit suivant la revendication 1, caractérisé en ce que le signal d'entrée est appliqué inversé à une entrée d'un multiplexeur (9) et non inversé à une autre entrée, que le dispositif intégrateur contient un intégrateur (16a) dont l'entrée est connectée à la sortie du multiplexeur, qu'un montage générateur de signaux d'horloge (6) piloté par le signal de référence est prévu pour l'activation de l'intégrateur pendant les intervalles d'intégration et pour la commutation du multiplexeur entre les intervalles de temps et que la sortie de l'intégrateur forme la sortie du montage de circuit.

3. Montage de circuit suivant la revendication 1, caractérisé en ce que le dispositif d'intégration comprend deux intégrateurs (16b, c) aux entrées desquels est appliqué le signal d'entrée, qu'un montage générateur de signaux d'horloge (6) piloté par le signal de référence est prévu pour l'activation du permier intégrateur pendant le premier intervalle de temps et du second intégrateur pendant le second intervalle de temps que les signaux de sortie pondérés des deux intégrateurs sont appliqués aux entrées du circuit de superposition (10d) et que la sortie du montage de circuit est couplée à la sortie du circuit de superposition.

4. Montage de circuit suivant l'une quelconque des revendications précédentes, caractérisé en ce que le premier intervalle d'intégration est inférieur ou égal au temps de montée d'un signal d'entrée impulsionnel et que les deux intervalles d'intégration sont séparés par un délai tel que pour une différence de phase définie, le premier intervalle d'intégration coïncide dans le temps avec le flanc antérieur du signal d'entrée et le second intervalle d'intégration, avec le palier d'impulsion du signal d'entrée et que les longueurs des deux intervalles d'intégration et les facteurs de pondération sont choisis tels que le signal de sortie possède une valeur définie.

5. Montage de circuit suivant la revendication 3, caractérisé en ce que qu'un circuit de division (12) divise le signal de sortie du circuit de superposition par le signal de sortie de l'intégrateur qui est activé pendant le second intervalle d'intégration.

6. Montage de circuit suivant la revendication 5, caractérisé en ce que le circuit de superposition est suivi d'un circuit limiteur (14).

7. Montage de circuit suivant la revendication 2, caractérisé en ce que la position dans le temps des signaux de commande fournis au multiplexeur par le montage générateur de signaux d'horloge dépend du passage par zéro du signal de référence impulsionnel.

8. Montage de circuit suivant l'une quelconque des revendications précédentes, caractérisé en ce que le signal d'entrée est appliqué par l'intermédiaire d'un convertisseur analogique-numérique (1) dont la fréquence d'échantillonnage est un multiple entier de la fréquence de l'impulsion de référence et que le ou les intégrateurs sont pilotés par le montage générateur de signaux d'horloge d'une manière telle qu'un nombre fixe de valeurs d'échantillonnage du signal d'entrée soit chaque fois intégré.

9. Montage de circuit suivant la revendication 8, caractérisé en ce que le signal d'entrée est appliqué par l'intermédiaire d'un filtre passe-bas (2).

**Claims**

1. A circuit arrangement for detecting the phase deviation betweeen an input signal (Uc) and a reference signal (Ur), which produces an output signal which depends on said phase deviation by integrating the input signal during an integration interval which is in synchronism with the reference signal, characterized in that the circuit arrangement comprises an integrator arrangement, (16a, b, c) for integrating the input signal during two consecutive defined integration intervals and a superposition circuit (10a, d) for forming a signal which corresponds to the difference between weighted integral values produced at the integrator arrangement, the weighting factors and/or the duration of the intergration intervals, respectively deviating from each other, this signal constituting the output signal of the circuit arrangement.

2. A circuit arrangement as claimed in Claim 1, characterized in that the input signal inverts an input of a multiplexer (9) and is applied in the non-inverted form to another input, that the integrator arrangement comprises an integrator (16a) whose input is connected to the output of the multiplexer, a timing device (6) controlled by a reference signal being provided for setting the integrator into operation during the integration interval and for switching the multiplexer between the time intervals, the output of the integrator constituting the output of the circuit arrangement.

3. A circuit arrangement as claimed in Claim 1, characterized in that the integration arrangement comprises two integrators (16b, c) at whose inputs the input signal is present, a timing device (6) controlled by the reference signal being provided for setting one integrator into operation during the first time interval and the second integrator during the second time interval, the weighted output signals of the two integrators being applied to inputs of the superposition circuit (10d), and the output of the circuit arrangement being coupled to the output of the superposition circuit.

4. A circuit arrangement as claimed in anyone of the preceding Claims, characterized in that the first intergration interval is shorter than or equal to the rise time of a pulse-shaped input signal and that the two integration intervals are spaced from each other such that at a defined phase difference the first integration interval coincides with the rising edge of the input signal and the second integration interval coincides with the pulse top of the input signal and that the durations of the two integration intervals and the weighting factors are chosen such that the output signal has a defined value.

5. A circuit arrangement as claimed in Claim 4, characterized in that a divider circuit (12) is provided for dividing the output signal of the superposition circuit by the output signal of the integrator, which is set into operation during the second integration interval.

6. A circuit arrangement as claimed in Claim 5, characterized in that the superposition circuit is followed by a limiter circuit (14).

7. A circuit arrangement as claimed in Claim 2, characterized in that the position in time of the control signal applied to the multiplexer by the timing device depends on the zero-crossing of the pulse-shape reference signal.

8. A circuit arrangement as claimed in anyone of the preceding Claims, characterized in that the input signal is applied via an analog-digital converter (1) whose sampling frequence is an integral multiple of the frequency of the reference pulse, the integrator or integrators being controlled by the timing device such that always a fixed number of sampling values of the input signal is integrated.

9. A circuit arrangement as claimed in Claim 8, characterized in that the input signal is applied via a low-pass filter (2).

FIG.1

FIG.2

FIG.4

FIG.3

FIG.5